# EUROPEAN PATENT SPECIFICATION

(11) **EP 1 726 197 B1**
(45) Date of publication and mention of the grant of the patent: **30.07.2008**
(21) Application number: 05706817.3
(22) Date of filing: 09.03.2005
(51) Int. Cl.: H05K 7/20, H01L 23/34

(54) **AN ELEMENT FOR CARRYING ELECTRONIC COMPONENTS**
ELEMENT ZUM TRAGEN ELEKTRONSICHER BAUTEILE
ELEMENT CONÇU POUR SUPPORTER DES COMPOSANTS ELECTRONIQUES

(30) Priority: 11.03.2004 DK 200400392
(43) Date of publication of application: 29.11.2006
(73) Proprietor: Danfoss Silicon Power GmbH, 24837 Schleswig (DE)
(72) Inventor: OLESEN, Klaus, Kristen, DK-6400 Sønderborg (DK)
(74) Representative: Inspicos A/S
(86) International application number: PCT/DK2005/000156
(87) International publication number: WO 2005/089034

(56) References cited:
- FR-A- 2 786 658
- US-A- 4 573 067
- US-A1- 2002 043 716
- US-A1- 2003 178 182

## Description

### Introduction

The present invention relates to an element with an electrically conductive top layer for attaching an electronic component, an electrically conductive back layer which is electrically isolated from the top layer by an isolating layer, and a manifold plate with an inner surface attached to an outer surface of the back layer. An outer surface of the back layer comprises a plurality of outwardly open grooves.
The grooves are covered by an inner surface of a manifold plate to form cells which each extends mutually separated between an inlet and an outlet to facilitate circulation of a heat exchange medium in each of the cells individually.

### Background of the invention

Elements of the above mentioned kind are widely used for electronic circuits.

Typically, the components are surface mounted to the outer surface of the top layer, and a surface pattern of the top layer forms conductive paths between the components to form an electrical circuit. The electrical components normally generate heat during operation, and the heat dissipates into the element. In some applications it is necessary to cool down the electronic components, e. g. by establishing thermal conduction between one surface of the element and a cooling fluid. Systems for distributing a fluid onto the surface of an element is known e. g. from WO 03/095922 wherein a bottom side plate of a semi-conductor unit is cooled by a liquid which is guided along the plate by means of a distribution element. The distribution element is divided into cells, where each cell has a liquid inlet and a liquid outlet perpendicular to the cooled plate, and the distributing element has multiple cells along the plate. In US 5, 269, 372, a cold plate for cooling electronic modules incorporates a flow network with supply and return conduits for a cooling fluid, and in US application no. 2001/0050162. a plurality of plate elements are stacked to form a core with a heat-transfer surface which can be arranged towards a microprocessor device. In the above-mentioned distributors, the fluid is guided in a device which is separate from the element which carries the components to be cooled. Even though this separation allows a certain degree of freedom during a manufacturing and assembling process, it results in relatively high manufacturing and assembling costs.

US 2002/0043716 discloses an apparatus for removing heat from a heat generating device which is mounted to a top-side surface of a package substrate. A fluid flow channel is defined at least partially by a portion of the back-side surface of the substrate to reduce overall thermal resistance between the heat generating device and cooling medium.

FR-A-2 786 658 discloses a manufacturing process for an element for cooling power components. The process comprises making of conduits in a sub base of a composite structure.

### Description of the invention

It is an object of the present invention to enable a more uniform cooling of an electronic component in a simple and reliable manner. Accordingly, the invention, in a first aspect, provides a substrate of the kind mentioned in the introduction in which the grooves are etched all the way through the back layer, while the back layer was attached to the isolating layer.

Since the grooves are etched all the way through the back layer, a more uniform cross- sectional size of the cells can be achieved and a more uniform cooling may thus be obtained.

As an example, the cross-sectional size may increase towards a centre-part of the element to conduct a larger amount of the medium through the centre-part than through the surrounding periphery of the element.

The top and back layers could be made from aluminium or copper and the isolating layer could be made from a polymeric material to form a so called IMS substrate. However, in a preferred embodiment, the isolating layer is made from a ceramic material to form a so called DCB substrate. Both IMS and DCB substrates are well known in the art and can be obtained from electronic suppliers according to standard specifications for the thicknesses of each of the layers. The cells may therefo re be made by forming grooves, i.e. depressions of any shape in the outer su rface of the back layer, e.g. of a standard IMS or DCB substrate. The grooves may be closed by an inner surface of a manifold-plate which is attached to the outer surface of the back layer. If the isolating layer is made from a material which is resistant to the cooling fluid, the grooves could be made throughout the back layer, e.g. by an etching process, this could e.g. be the case in a DCB substrate, wherein most ceramic materials are resistant to acids. In order to establish specific electrical connectivity between components which are fastened to the outer surface of the first conductive layer, it is known to etch material away from the top layer to form a pattern of conductive paths. During this etching process and using a similar technology, the grooves could be etched into the back layer.

In IMS substrates, the grooves may be made by a milling cutter, and into a depth partly through the back layer. In this way, the remaining part of the back layer protectively shields the isolating, polymeric, layer from the cooling fluid, which fluid may destroy or penetrate the back layer and thus cause a short circuiting of the top and back layers. The width of the grooves may preferably be in the size of, or larger than the depth of the grooves.

The inlet manifold and the outlet manifold could be formed by grooves formed in the inner surface of the manifold-plate. These grooves could have a cross sectional area in the size of, or larger than the cross sectional areas of the cells, and in order to provide all cells with cooling fluid in parallel, the inlet manifold may be in fluid communication with cell inlets in one end of the cells. Correspondingly, the outlet manifold may be in fluid communication with cell outlets in an opposite end of the cells. In this way, it is provided that the fluid is guided into all of the cells with substantially the same temperature and the variations in the temperature across the element may thus be reduced.

The manifold-plate could be joined to the back layer e.g. adhesively or by soldering.

The manifold-plate may have an inlet opening into the inlet manifold groove and an outlet opening into the outlet manifold groove. The openings could be formed in an outer surface, opposite the inner surface. From the openings, the fluid could be guided to a heat exchanger to be cooled down.

As an example, the fluid could be a refrigerant of a type well known from refrigeration systems, and in a complete setup, the fluid could be exchanged between the electronics and a compressor to force a phase shift between gas phase and liquid phase of the refrigerant to absorb and emit heat energy, respectively.

The cells formed into the back layer may preferably have meandering shapes to cause a fluid which is guided therein to change flow direction, e.g. repeatedly.

A particularly easy manufacturing process may be obtained by designing the manifold-plate as a laminated structure comprising a first layer with the inlet manifold and the outlet manifold formed as through going openings through the first layer, and a second layer with the inlet opening and the outlet formed as through going openings through the second layer. In that way, the at least two plates of the laminated manifold-plate structure could be made in a stamping process.

In a second aspect, the invention relates to a method of making an element for carrying electronic components, said element comprising an electrically conductive top layer for attaching an electronic component, and an electrically conductive back layer which is electrically isolated from the top layer by an isolating layer, wherein an outer surface of the back layer comprises a plurality of outwardly open grooves, wherein an surface of a manifold plate is attached to the outer surface of the back layer to form cells which each extends mutually separated between an inlet and an outlet to facilitate circulation of a heat exchange medium in each of the cells individually, **characterised by** the steps of first attaching the isolating layer to the backlayer before the grooves are formed by etching all the way through the back layer.

The method includes steps which are necessary to provide any of the features of the element according to the first aspect of the invention. In particular, the grooves are formed throughout the back layer by etching.

The invention is not limited to cooling of electronic components, but could without further considerations be adapted also for heating electronic components. The invention could be combined with any kind of refrigeration or heating system, e.g. with a compressor and a refrigerant of a kind known in the art.

### Detailed description of the invention

In the following, the invention will be described in further details with reference to the drawing in which:
Figs. 1 and 2 show perspective views of the element seen from above and from below, respectively,
Fig. 3 shows a manifold-plate with grooves forming the inlet manifold and the outlet manifold,
Fig. 4 shows an embodiment wherein the manifold plate is made from a laminate of two plates,
Fig. 5 shows a specific shape of the cells and corresponding locations of the inlet and outlet manifolds,
Fig. 6 shows an embodiment wherein the manifold-plate comprises fins for improving thermal convection to the ambience, and
Fig. 7 shows a view of a complete system for cooling electronic components.

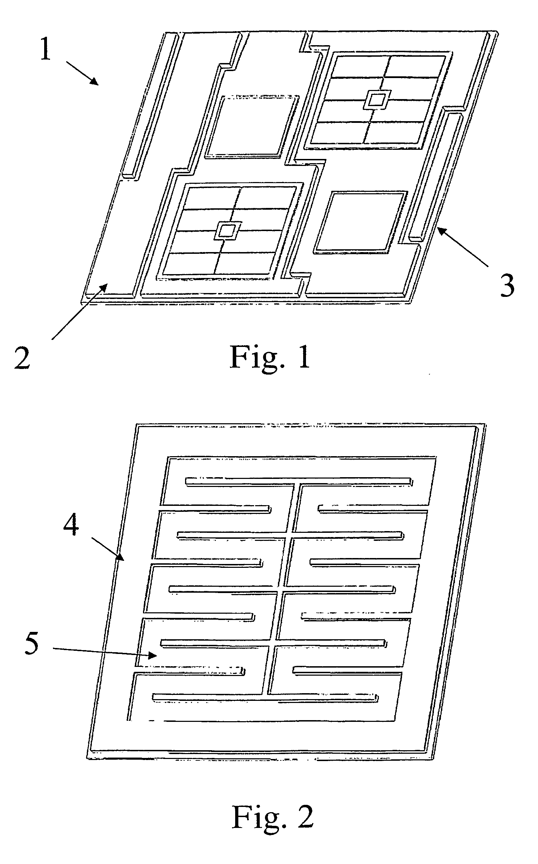

Fig. 1 shows an element 1 for carrying electronic components. The element 1 comprises a first electrically conductive top layer 2 with an outer surface to which the electronic components can be attached. The outer surface forms a surface pattern of conductive paths establishing connectivity between electrical components which are bonded to the surface. The opposite inner surface of the first layer is attached to a third isolating layer 3 of a non conductive material, e.g. a polymeric material or a ceramic material.

As shown in Fig. 2, the third layer is, on its opposite side, attached to an inner surface of a second conductive back layer 4. The back layer has an outer surface which comprises grooves 5 forming cells for a heat exchange medium, e.g. a cooling fluid of the kind known from refrigeration systems known in the art. As shown, the grooves 5 are formed with a meandering shape to cause changes in the direction of a fluid flow therein.

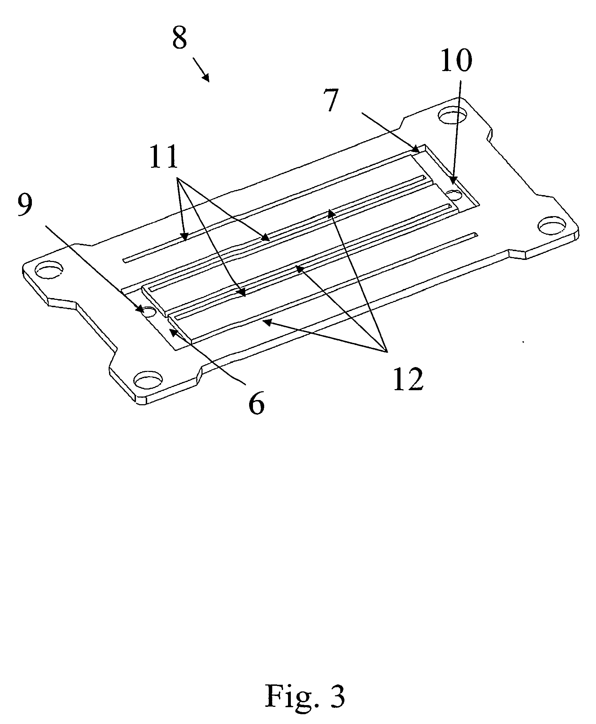

The cells are in fluid communication with an inlet manifold 6 and with an outlet manifold 7. As shown in fig. 3, the manifolds are made as grooves into a manifold plate 8. When the manifold plate is fastened to the second conductive layer 4, the cells and the manifolds are enclosed by the manifold plate and the second layer, and cells which each extends mutually separated between an inlet and an outlet to facilitate circulation of a heat exchange medium in each of the cells individually. The inlets of all the cells are connected to a common inlet manifold and the outlets are connected to a common outlet manifold for circulation of the medium in parallel between the inlet manifold and the outlet manifold.

The manifold plate could be fastened to the second conductive layer, e.g. by joining the inner surface of the manifold-plate to the outer surface of the second conductive layer by soldering or gluing, or the two parts could be joined in a frame to which they are both attached.

The manifolds and the cells distribute a flow of a fluid through the second layer and thereby cool electronic components which are fastened to the first layer.

In addition to the inlet and the outlet manifold-grooves 6, 7, the manifold plate comprises an inlet opening 9 leading from an outer surface into the inlet groove, and an outlet opening 10 leading from the groove to an outer surface.
The manifold-grooves 6, 7 comprises first portions having a larger cross sectional area in a location around the inlet opening and the outlet opening, and fingers 11-12 extending from the first portion and being in fluid communication with a plurality of cells. Fingers 11 connecting the inlet manifold with an inlet of the cells are arranged alternating fingers 12 connecting the outlet manifold with an outlet of the cells.

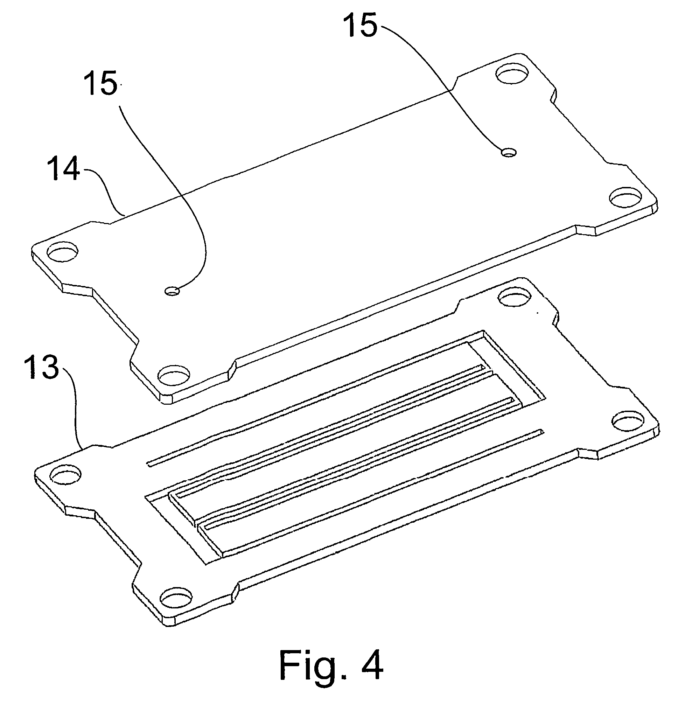

Fig. 4 shows a view of a manifold plate which is made as a laminated structure comprising a first plate 13 forming the inlet and outlet manifolds with a plurality of fingers for conducting fluid from to the inlets and outlets of the cells. The manifolds are formed as through going openings throughout the plate thickness. The second plate 14 comprises a plurality of openings 15 constituting the inlet openings and outlet openings when the first and second plates are joined to form the manifold plate.

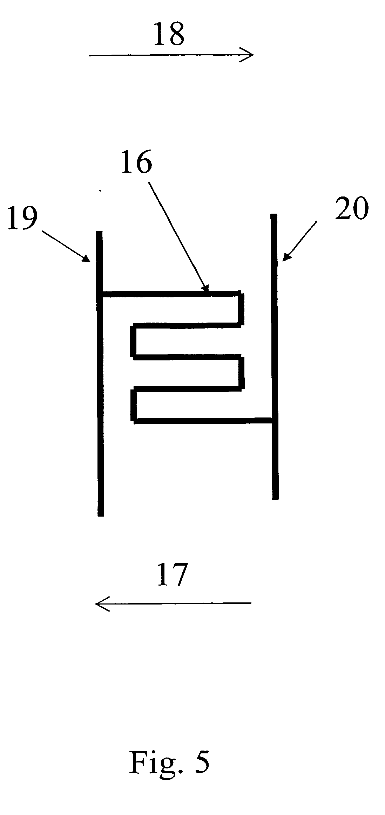

Fig. 5 shows a specific shape of the cells 16, wherein they form a meandering shape with the inlet extending in one direction indicated by the arrow 17 and the outlet extending in an opposite direction indicated by the arrow 18. The inlet manifold 19 is arranged on one side of the meandering cell, in fluid communication with the inlet of the cell. Correspondingly, the outlet manifold 20 is arranged on an opposite side of the meandering cell and in fluid communication with the outlet of the cell.

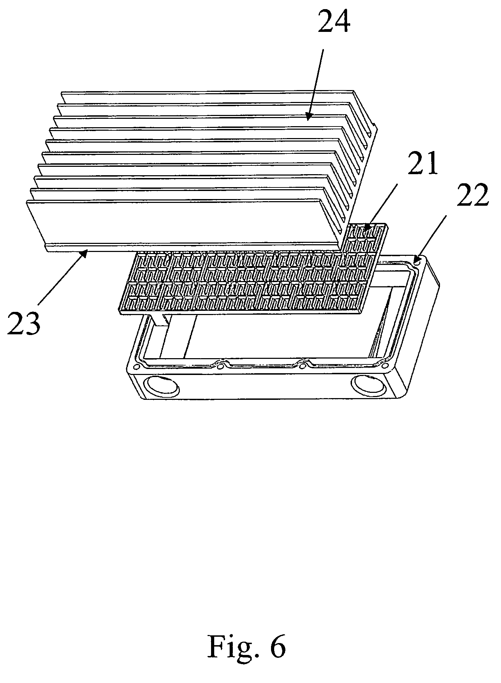

Fig. 6 shows a cooling device wherein the element 21 is inserted into a frame 22. The element comprises a plurality of meandering grooves which is sealed off with a manifold plate 23. The cooling plate comprises manifold groove in the surface which faces towards the element, i.e. the surface which is not visible in Fig. 6. Accordingly, pluralities of cells interconnected by manifolds are formed between the element 21 and the manifold plate 23. The manifold plate further comprises a heat conductive feature 24 in the form of fins extending from an outer surface of the manifold plate, i.e. the surface facing away from the element.

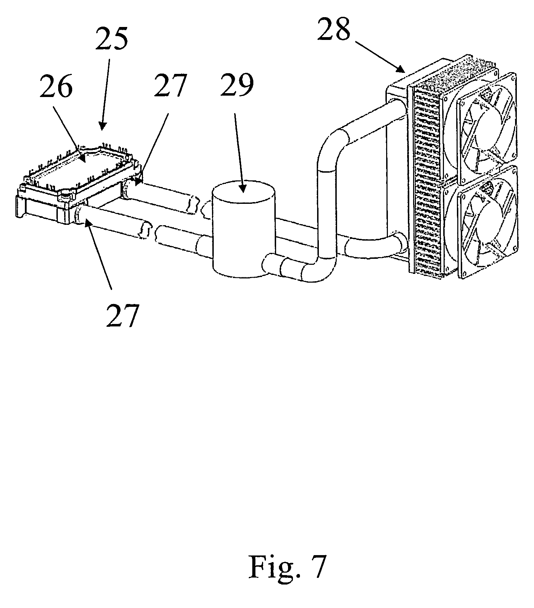

Fig. 7 shows a more complete system comprising an electronic component 25 build onto an element 26 according to the present invention. The system further comprises a set of pipes 27 forming a loop for exchanging a cooling fluid between a refrigeration system 28 and the element 26. The system further comprises a combined filter and buffer storage tank 29.

## Claims

1. An element (1) with an electrically conductive top layer (2) for attaching an electronic component, an electrically conductive back layer (4) which is electrically isolated from the top layer by an isolating layer (3), and a manifold plate (8) with an inner surface attached to an outer surface of the back layer, wherein the outer surface of the back layer comprises a plurality of outwardly open rooves (5), the grooves being covered by the inner surface of a manifold plate to form cells which each extends mutually separated between an inlet and an outlet to facilitate circulation of a heat exchange medium in each of the cells individually, **characterised in that** the grooves (5) are etched all the way through the back layer while the back layer was attached to the isolating layer*.*

2. An element according to claim 1, wherein the inlets are connected to a common inlet manifold (6) and the outlets are connected to a common outlet manifold (7) for circulation of the medium in parallel between the inlet manifold and the outlet manifold.

3. An element according to claim 2, wherein at least one of the inlet manifold and the outlet manifolds is formed as a groove in at least one of the outer surface of the back layer and the inner surface of the manifold plate.

4. An element according to any of the preceding claims, wherein the cross-sectional sizes of the grooves increase towards a centre-part of the element.

5. An element according to any of the preceding claims, wherein the cells have meandering shapes to cause a fluid which is guided therein to change its flow direction.

6. An element according to claim 5, wherein the cells extend in a first direction between the inlet and the outlet, and wherein the manifolds extends in a second direction intersecting the first direction.

7. An element according to any of the preceding claims, wherein the manifold plate is joined adhesively, or by soldering to the back layer.

8. An element according to any of the preceding claims, wherein the manifold plate comprises an inlet opening into the inlet manifold and an outlet opening into the outlet manifold, the openings being formed in an outer surface of the manifold plate, opposite the inner surface.

9. An element according to claim 8, wherein the manifold-plate has a laminated structure comprising a first layer forming the inlet manifold and the outlet manifold as through going openings through the first layer, and a second layer with the inlet opening and the outlet opening formed as through going openings through the second layer.

10. An element according to any of the preceding claims, wherein the isolating layer is made from a ceramic material to form a DCB-substrate for surface mounting of electronic components.

11. An element according to any of claims 1-9, wherein the isolating layer is made from a polymeric material to form an IMS-substrate for surface mounting of electronic components.

12. A method of making an element for carrying electronic components, said element comprising an electrically conductive top layer for attaching an electronic component, and an electrically conductive back layer which is electrically isolated from the top layer by an isolating layer, wherein an outer surface of the back layer comprises a plurality of outwardly open grooves, which are closed by an inner surface of a manifold plate which is attached to the outer surface of the back layer to form cells which each extends mutually separated between an inlet and an outlet to facilitate circulation of a heat exchange medium in each of the cells individually **characterized by** the steps of first attaching the isolating layer to the back layer before the grooves are formed by etching all the way through the back layer.

13. A method according to claim 12, wherein the etching is performed simultaneous with an etching of the top layer to form conductive paths between components attached thereto.

## Patentansprüche

1. Ein Element (1) mit einer elektrisch leitenden Oberschicht (2) zur Befestigung einer elektrischen Komponente, einer elektrisch leitenden, hinteren Schicht (4), die durch eine Isolierschicht (3) vom Oberschicht elektrisch isoliert ist, und eine Verteilerplatte (8) mit einer inneren Oberfläche, die mit einer äußeren Oberfläche der hinteren Schicht verbunden ist, wobei die äußere Oberfläche der hinteren Schicht eine Vielzahl von nach außen offenen Nuten (5) aufweist, die von der inneren Oberfläche einer Verteilerplatte zur Bildung von Zellen abgedeckt sind, die sich, gegenseitig getrennt, zur Vereinfachung einer individuellen Zirkulation eines Wärmeaustauschmediums in jeder Zelle zwischen einem Einlass und einem Auslass erstrecken, **dadurch gekennzeichnet, dass** die Nuten (5) während der Befestigung der hinteren Schicht an der Isolierschicht durch die hintere Schicht hindurch geätzt werden.

2. Ein Element nach Anspruch 1, in dem die Einlässe mit einem gemeinsamen Einlassverteiler (6) und die Auslässe mit einem gemeinsamen Auslassverteiler (7) zur parallelen Zirkulation des Mediums zwischen dem Einlassverteiler und dem Auslassverteiler verbunden sind.

3. Ein Element nach Anspruch 2, in dem mindestens der Einlassverteiler oder der Auslassverteiler als eine Nut in mindestens der äußeren Oberfläche der hinteren Schicht oder der inneren Oberfläche der Verteilerplatte ausgebildet ist.

4. Ein Element nach jedem der vorhergehenden Ansprüche, in dem die sich Querschnittdimensionen der Nuten in Richtung eines Mittelteils vom Element vergrößern.

5. Ein Element nach jedem der vorhergehenden Ansprüche, in dem die Zellen mäanderförmig sind um eine Flüssigkeit, die **dadurch** geführt wird, zu einer Richtungsänderung zu zwingen.

6. Ein Element nach Anspruch 5, in dem sich die Zellen in eine erste Richtung zwischen dem Einlass und dem Auslass erstrecken und in dem sich die Verteiler in eine zweite Richtung erstrecken, die die erste Richtung schneidet.

7. Ein Element nach jedem der vorhergehenden Ansprüche, in dem die Verteilerplatte durch Kleben, oder durch Verlötung mit der hinteren Schicht, verbunden ist.

8. Ein Element nach jedem der vorhergehenden Ansprüche, in dem die Verteilerplatte eine Einlassöffnung in den Einlassverteiler hinein und eine Auslassöffnung aus dem Auslassverteiler hinaus aufweist, wobei die Öffnungen in einer äußeren Oberfläche der Verteilerplatte ausgebildet sind, die der inneren Oberfläche gegenüberliegt.

9. Ein Element nach Anspruch 8, in dem die Verteilerplatte eine laminierte Struktur hat, die eine erste Schicht aufweist, die den Einlassverteiler und den Auslassverteiler als durchgehende Öffnungen durch die erste Schicht ausbildet, und eine zweite Schicht mit der Einlassöffnung und der Auslassöffnung, die als durchgehende Öffnungen durch die zweite Schicht ausgebildet sind.

10. Ein Element nach jedem der vorhergehenden Ansprüche, in dem die Isolierschicht aus einem Keramikmaterial hergestellt ist um ein DCB-Substrat zur Oberflächenmontage von elektronischen Komponenten zu bilden.

11. Ein Element nach jedem der Ansprüche 1-9, in dem die Isolierschicht aus einem Polymermaterial hergestellt ist um ein IMS-Substrat zur Oberflächenmontage von elektronischen Komponenten zu bilden.

12. Ein Verfahren zur Herstellung eines Elementes zum Tragen von elektronischen Komponenten, wobei das Element eine elektrisch leitende Oberschicht zur Befestigung einer elektrischen Komponente, und eine elektrisch leitende, hintere Schicht, die durch eine Isolierschicht vom Oberschicht elektrisch isoliert ist, wobei die äußere Oberfläche der hinteren Schicht eine Vielzahl von nach außen offenen Nuten aufweist, die von der inneren Oberfläche einer Verteilerplatte zur Bildung von Zellen abgedeckt sind, die sich, gegenseitig getrennt, zur Vereinfachung einer individuellen Zirkulation eines Wärmeaustauschmediums in jeder Zelle zwischen einem Einlass und einem Auslass erstrecken, **gekennzeichnet durch** die Stufen der Befestigung der Isolierschicht an der hinteren Schicht vor der Ausbildung der Nuten **durch** Ätzen **durch** die hintere Schicht hindurch.

13. Ein Verfahren nach Anspruch 12, bei dem das Ätzen gleichzeitig mit einem Ätzen der Oberschicht zur Ausbildung von leitenden Bahnen zwischen darauf befestigten Komponenten erfolgt.

## Revendications

1. Elément (1) comportant une couche supérieure électriquement conductrice (2) pour fixer un composant électronique, une couche arrière électriquement conductrice (4) qui est électriquement isolée de la couche supérieure par une couche isolante (3) et une plaque de collecteur (8) avec une surface interne fixée à une surface externe de la couche arrière, dans lequel la surface externe de la couche arrière comprend une pluralité de rainures ouvertes vers l'extérieur (5), les rainures étant couvertes par la surface interne d'une plaque de collecteur pour former des cellules s'étendant chacune mutuellement séparément entre une entrée et une sortie pour faciliter la circulation d'un milieu d'échange de chaleur dans chacune des cellules individuellement, **caractérisé en ce que** les rainures (5) sont gravées sur toute l'épaisseur de la couche arrière pendant que la couche arrière est fixée à la couche isolante.

2. Elément selon la revendication 1, dans lequel les entrées sont raccordées à un collecteur d'entrée commun (6) et les sorties sont raccordées à un collecteur de sortie commun (7) pour une circulation du milieu en parallèle entre le collecteur d'entrée et le collecteur de sortie.

3. Elément selon la revendication 2, dans lequel au moins l'un du collecteur d'entrée et du collecteur de sortie est formé comme une rainure dans au moins l'une de la surface externe de la couche arrière et de la surface interne de la plaque de collecteur.

4. Elément selon l'une quelconque des revendications précédentes, dans lequel les tailles en coupe transversale des rainures augmentent vers une partie centrale de l'élément.

5. Elément selon l'une quelconque des revendications précédentes, dans lequel les cellules ont des formes sinueuses pour amener un fluide qui est guidé à l'intérieur de celles-ci à changer sa direction d'écoulement.

6. Elément selon la revendication 5, dans lequel les cellules s'étendent dans une première direction entre l'entrée et la sortie et dans lequel les collecteurs s'étendent dans une seconde direction croisant la première direction.

7. Elément selon l'une quelconque des revendications précédentes, dans lequel la plaque de collecteur est jointe d'une façon adhésive ou par brasage à la couche arrière.

8. Elément selon l'une quelconque des revendications précédentes, dans lequel la plaque de collecteur comprend une ouverture d'entrée dans le collecteur d'entrée et une ouverture de sortie dans le collecteur de sortie, les ouvertures étant formées dans une surface externe de la plaque de collecteur, opposée à la surface interne.

9. Elément selon la revendication 8, dans lequel la plaque de collecteur présente une structure stratifiée comprenant une première couche formant le collecteur d'entrée et le collecteur de sortie sous la forme d'ouvertures traversantes à travers la première couche et une seconde couche avec l'ouverture d'entrée et l'ouverture de sortie formées comme des ouvertures traversantes à travers la seconde couche.

10. Elément selon l'une quelconque des revendications précédentes, dans lequel la couche isolante est constituée d'un matériau céramique pour former un substrat DCB (diffusion directe du cuivre) pour le montage en surface de composants électroniques.

11. Elément selon l'une quelconque des revendications 1 à 9, dans lequel la couche isolante est constituée d'un matériau polymère pour former un substrat IMS (substrat métallique isolé) pour un montage en surface de composants électroniques.

12. Procédé de fabrication d'un élément destiné à porter des composants électroniques, ledit élément comprenant une couche supérieure électriquement conductrice destinée à fixer un composant électronique et une couche arrière électriquement conductrice qui est électriquement isolée de la couche supérieure par une couche isolante, dans lequel une surface externe de la couche arrière comprend une pluralité de rainures ouvertes vers l'extérieur qui sont fermées par une surface interne d'une plaque de collecteur qui est fixée à la surface externe de la couche arrière pour former des cellules qui s'étendent chacune mutuellement séparément entre une entrée et une sortie pour faciliter la circulation d'un milieu d'échange de chaleur dans chacune des cellules individuellement, **caractérisé par** les étapes consistant à fixer tout d'abord la couche isolante à la couche arrière avant la formation des rainures par gravure sur toute l'épaisseur de la couche arrière.

13. Procédé selon la revendication 12, dans lequel la gravure est effectuée simultanément à une gravure de la couche supérieure pour former les trajets conducteurs entre les composants fixés sur celle-ci.
